# EUROPEAN PATENT APPLICATION

(11) **EP 4 651 475 A1**
(43) Date of publication of application: **19.11.2025**
(21) Application number: 24792816.1
(22) Date of filing: 23.02.2024
(51) Int. Cl.: H04M 1/02, H05K 1/14

(54) **ELECTRONIC DEVICE INCLUDING STRUCTURE FOR SUPPORTING FLEXIBLE PRINTED CIRCUIT BOARD**

(30) Priority: 20.04.2023 KR 20230052197; 12.05.2023 KR 20230062034
(71) Applicant: Samsung Electronics Co., Ltd., Suwon-si, Gyeonggi-do 16677 (KR)
(72) Inventor: LEE, Ohhee, Suwon-si Gyeonggi-do 16677 (KR); KIM, Sanghyeon, Suwon-si Gyeonggi-do 16677 (KR); KIM, Hyelim, Suwon-si Gyeonggi-do 16677 (KR); LIM, Sunhwa, Suwon-si Gyeonggi-do 16677 (KR); JI, Junmin, Suwon-si Gyeonggi-do 16677 (KR); CHOI, Kwanmo, Suwon-si Gyeonggi-do 16677 (KR); CHOI, Jongchul, Suwon-si Gyeonggi-do 16677 (KR)
(74) Representative: Nederlandsch Octrooibureau
(86) International application number: PCT/KR2024/002400
(87) International publication number: WO 2024/219629

(57) **Abstract**

An electronic device is provided. The electronic device according to one embodiment comprises: a frame including a first surface, and a partition wall protruding from the first surface; a battery arranged on the first surface so as to be surrounded by the partition wall; a flexible printed circuit board which includes a bending portion bent in the partition wall, and which is connected to the battery; and a support member movably coupled to the partition wall, wherein a position of the support member includes: a first position coming in contact with the bending portion so as to apply, to the bending portion, force in the direction toward the first surface; and a second position spaced apart from the bending portion.

## Description

### [Technical Field]

The present disclosure relates to an electronic device including a structure for supporting a flexible printed circuit board.

### [Background Art]

In order to meet a demand of a user, an electronic device may include electronic components capable of providing various functions. For example, an electronic component in the electronic device may be disposed in the electronic device in a state of being connected to a flexible printed circuit board. At least a portion of the flexible printed circuit board connected to the electronic component may be bent in the electronic device.

### [Disclosure]

### [Technical Solution]

An electronic device is provided. The electronic device according to an embodiment may comprise a frame including a first surface and a partition wall protruded from the first surface. According to an embodiment, the electronic device may comprise a battery disposed on the first surface to be surrounded by the partition wall. According to an embodiment, the electronic device may comprise a flexible printed circuit board, including a bending portion which is bent within the partition wall, connected to the battery. According to an embodiment, the electronic device may comprise a supporting member movably coupled to the partition wall. According to an embodiment, a position of the supporting member may comprise a first position contacted on the bending portion to apply force in a direction toward the first surface to the bending portion, and a second position spaced apart from the bending portion.

An electronic device is provided. According to an embodiment, the electronic device may comprise a frame including a first surface, a partition wall protruded from the first surface, and a first through-hole penetrating the partition wall. According to an embodiment, the electronic device may comprise a battery disposed on the first surface to be surrounded by the partition wall. According to an embodiment, the electronic device may comprise a flexible printed circuit board, including a bending portion which is bent within the partition wall, connected to the battery. According to an embodiment, the electronic device may comprise a supporting member, including a first portion passing through the first through-hole and a second portion connected to the first portion, separable from the partition wall. According to an embodiment, the first portion may be contacted on the bending portion to apply a force in a direction toward the first surface to the bending portion. According to an embodiment, the second portion may be positioned on an outer surface of the partition wall opposite to an inner surface of the partition wall facing the battery.

An electronic device is provided. According to an embodiment, the electronic device may comprise a frame. According to an embodiment, the electronic device may comprise an electronic component disposed on a first surface of the frame. According to an embodiment, the electronic device may comprise a bending portion having a shape which is bent, and a flexible printed circuit board connected to the electronic component. According to an embodiment, the electronic device may comprise a supporting member movably coupled to the frame. According to an embodiment, the supporting member may be contacted on the bending portion to apply force to the flexible printed circuit board in a direction facing the first surface by being moved with respect to the frame, or may be spaced apart from the bending portion.

### [Description of the Drawings]

FIG. 1 is a block diagram of an electronic device in a network environment according to various embodiments.
FIG. 2 is a diagram illustrating an exemplary electronic device according to an embodiment.
FIG. 3 is an exploded perspective view of an exemplary electronic device according to an embodiment.
FIG. 4A is a top plan view of an exemplary electronic device according to an embodiment.
FIG. 4B is an exploded perspective view illustrating an example of a method in which an exemplary supporting member and an exemplary frame are coupled to each other according to an embodiment.
FIG. 5 is a cross-sectional view illustrating an example in which an exemplary electronic device is cut along line A-A' of FIG. 4A according to an embodiment.
FIG. 6A is an enlarged perspective view of an exemplary electronic device according to an embodiment.
FIG. 6B is a cross-sectional view illustrating an example in which an exemplary electronic device is cut along line B-B' of FIG. 6A according to an embodiment.
FIG. 7A is a perspective view of an exemplary electronic device according to an embodiment.
FIG. 7B is a partial perspective view illustrating an example in which an exemplary electronic device is cut along line C-C' of FIG. 7A according to an embodiment.
FIG. 7C is an exploded perspective view illustrating an example of a method in which an exemplary supporting member and an exemplary frame are coupled to each other according to an embodiment.
FIG. 8A is a top plan view of an exemplary electronic device according to an embodiment.
FIG. 8B is a cross-sectional view illustrating an example in which an exemplary electronic device is cut along line D-D' of FIG. 8A according to an embodiment.
FIG. 8C is a cross-sectional view illustrating an example in which an exemplary electronic device is cut along line E-E' of FIG. 8A according to an embodiment.
FIG. 9A is an exploded perspective view illustrating an example of a method in which a frame is coupled to an exemplary supporting member according to an embodiment.
FIG. 9B is a perspective view of an exemplary electronic device according to an embodiment.
FIG. 10 is a cross-sectional view illustrating an example in which an exemplary electronic device is cut along line F-F' of FIG. 9B according to an embodiment.
FIG. 11A is a cross-sectional view illustrating an example in which an exemplary electronic device is cut along line G-G' of FIG. 9B according to an embodiment.
FIG. 11B is a cross-sectional view illustrating an example in which an exemplary electronic device is cut along line H-H' of FIG. 9B according to an embodiment.

### [Mode for Invention]

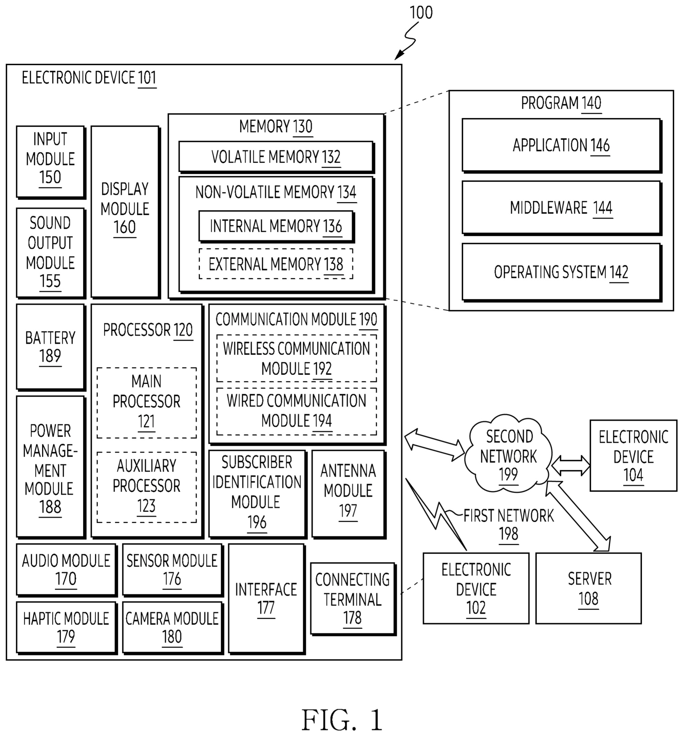

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form an mmWave antenna module. According to an embodiment, the mmWave antenna module may include a printed circuit board, an RFIC disposed on or adjacent to a first surface (e.g., a lower surface) of the printed circuit board and capable of supporting a preset high-frequency band (e.g., an mmWave band), and a plurality of antennas (e.g., array antennas) disposed on or adjacent to a second surface (e.g., an upper surface or a lateral side) of the printed circuit board and capable of transmitting or receiving signals in the preset high-frequency band.

At least some of the components are connected to each other through a communication method (e.g., a bus, a general purpose input and output (GPIO), a serial peripheral interface (SPI), or a mobile industry processor interface (MIPI)) between peripheral devices, and may exchange a signal (e.g., a command or data) with each other.

According to an embodiment, the command or the data may be transmitted or received between the electronic device 101 and the external electronic device 104 through the server 108 connected to the second network 199. Each of the external electronic devices 102 or 104 may be the same or different types of devices as the electronic device 101. According to an embodiment, all or some of operations executed in the electronic device 101 may be executed in one or more external electronic devices among the external electronic devices 102, 104, or 108. For example, in a case that the electronic device 101 needs to perform a function or a service automatically or in response to a request from a user or another device, the electronic device 101 may request the one or more external electronic devices to perform at least a portion of the function or the service instead of executing the function or the service itself. The one or more external electronic devices receiving the request may execute at least a portion of the requested function or service, or an additional function or service associated with the request, and then transmit a result of the execution to the electronic device 101. The electronic device 101 may process the result as it is or additionally, and provide it as at least a portion of a response to the request. For this, for example, cloud computing, distributed computing, mobile edge computing (MEC), or client-server computing technology may be used. The electronic device 101 may provide, for example, an ultra-low latency service using the distributed computing or the mobile edge computing. In another embodiment, the external electronic device 104 may include an Internet of Things (IoT) device. The server 108 may be an intelligent server using machine learning and/or a neural network. According to an embodiment, the external electronic device 104 or the server 108 may be included in the second network 199. The electronic device 101 may be applied to an intelligent service (e.g., a smart home, a smart city, a smart car, or healthcare) based on 5G communication technology and IoT-related technology.

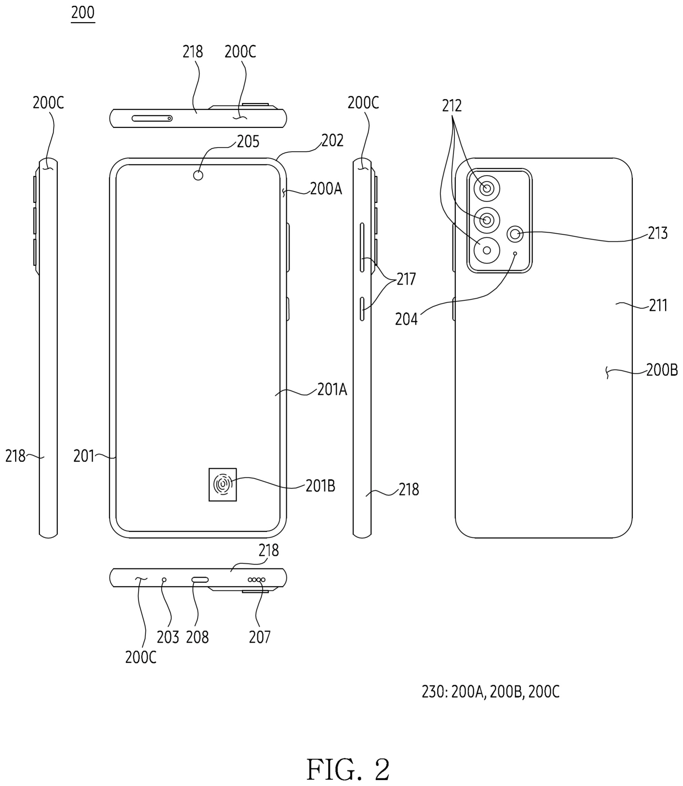

FIG. 2 is a diagram illustrating an electronic device according to an embodiment.

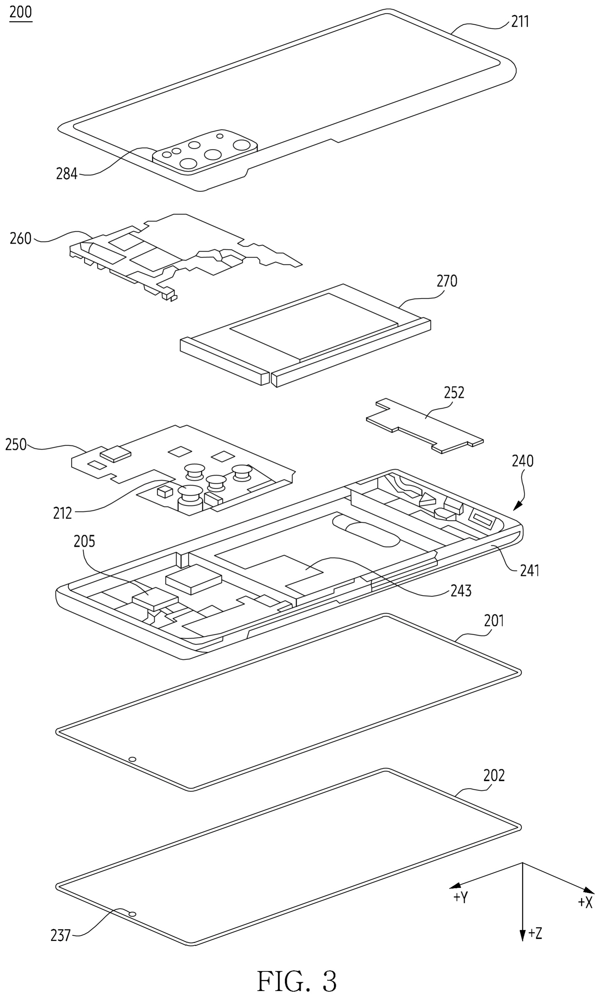

Referring to FIG. 2, an electronic device 200 (e.g., the electronic device 101 of FIG. 1) according to an embodiment may include a housing 230 that forms an exterior of the electronic device 200. For example, the housing 230 may include a first surface (or a front surface) 200A, a second surface (or a rear surface) 200B, and a third surface (or a lateral side) 200C surrounding a space between the first surface 200A and the second surface 200B. In an embodiment, the housing 230 may refer to a structure (e.g., a frame 240 of FIG. 3) forming at least a portion of the first surface 200A, the second surface 200B, and/or the third surface 200C.

The electronic device 200 according to an embodiment may include a substantially transparent front plate 202. In an embodiment, the front plate 202 may form at least a portion of the first surface 200A. In an embodiment, the front plate 202 may include, for example, a glass plate including various coating layers, or a polymer plate, but is not limited thereto.

The electronic device 200 according to an embodiment may include a substantially opaque rear plate 211. In an embodiment, the rear plate 211 may form at least a portion of the second surface 200B. In an embodiment, the rear plate 211 may be formed of coated or colored glass, ceramic, polymer, metal (e.g., aluminum, stainless steel (STS), or magnesium), or a combination of at least two of the materials.

The electronic device 200 according to an embodiment may include a side bezel structure (or a side member) 218 (e.g., a sidewall 241 of the frame 240 of FIG. 3). In an embodiment, the side bezel structure 218 may be coupled to the front plate 202 and/or the rear plate 211 to form at least a portion of the third surface 200C of the electronic device 200. For example, the side bezel structure 218 may form the entire third surface 200C of the electronic device 200, and in an embodiment, the side bezel structure 218 may form the third surface 200C of the electronic device 200 together with the front plate 202 and/or the rear plate 211.

In an embodiment (not illustrated), in a case that the third surface 200C of the electronic device 200 is partially formed by the front plate 202 and/or the rear plate 211, the front plate 202 and/or the rear plate 211 may include a region that seamlessly extends by being curved from its periphery toward the rear plate 211 and/or the front plate 202. The extending region of the front plate 202 and/or the rear plate 211 may be positioned, for example, at both ends of a long edge of the electronic device 200, but is not limited by the above-described example.

In an embodiment, the side bezel structure 218 may include a metal and/or a polymer. In an embodiment, the rear plate 211 and the side bezel structure 218 may be integrally formed and may include the same material (e.g., a metallic material such as aluminum), but are not limited thereto. For example, the rear plate 211 and the side bezel structure 218 may be formed in separate configurations and/or may include different materials.

In an embodiment, the electronic device 200 may include at least one of a display 201, audio modules 203, 204, and 207, a sensor module (not illustrated), camera modules 205, 212, and 213, a key input device 217, a light-emitting element (not illustrated), and/or a connector hole 208. In an embodiment, the electronic device 200 may omit at least one (e.g., the key input device 217 or the light-emitting element (not illustrated)) of the components, or may additionally include another component.

In an embodiment, the display 201 (e.g., the display module 160 of FIG. 1) may be visually exposed through a significant portion of the front plate 202. For example, at least a portion of the display 201 may be visible through the front plate 202 forming the first surface 200A. In an embodiment, the display 201 may be disposed on a back surface of the front plate 202.

In an embodiment, an outer shape of the display 201 may be formed substantially the same as an outer shape of the front plate 202 adjacent to the display 201. In an embodiment, in order to expand an area in which the display 201 is visually exposed, a distance between an outer of the display 201 and an outer of the front plate 202 may be formed substantially the same.

In an embodiment, the display 201 (or the first surface 200A of the electronic device 200) may include a screen display region 201A. In an embodiment, the display 201 may provide visual information to a user through the screen display region 201A. In the illustrated embodiment, when the first surface 200A is viewed from the front, the screen display region 201A is illustrated as being positioned inside the first surface 200A by being spaced apart from an outer of the first surface 200A, but is not limited thereto. In an embodiment, when the first surface 200A is viewed from the front, at least a portion of a peripheral of the screen display region 201A may substantially coincide with a periphery of the first surface 200A (or the front plate 202).

In an embodiment, the screen display region 201A may include a sensing region 201B configured to obtain biometric information of the user. Herein, a meaning of "the screen display region 201A includes the sensing region 201B" may be understood as at least a portion of the sensing region 201B being overlapped with the screen display region 201A. For example, the sensing region 201B may mean a region in which the visual information may be displayed by the display 201 like another region of the screen display region 201A, and additionally obtain biometric information (e.g., a fingerprint) of the user. In an embodiment, the sensing region 201B may be formed in the key input device 217.

In an embodiment, the display 201 may include a region in which a first camera module 205 (e.g., the camera module 180 of FIG. 1) is positioned. In an embodiment, an opening is formed in the region of the display 201, and the first camera module 205 (e.g., a punch hole camera) may be at least partially disposed in the opening to face the first surface 200A. For example, the screen display region 201A may surround at least a portion of a periphery of the opening. In an embodiment, the first camera module 205 (e.g., an under display camera (UDC)) may be disposed under the display 201 to overlap the region of the display 201. For example, the display 201 may provide the visual information to the user through the region, and additionally, the first camera module 205 may obtain an image corresponding to a direction toward the first surface 200A through the region of the display 201.

In an embodiment, the display 201 may be combined or disposed adjacent to touch sensing circuitry, a pressure sensor capable of measuring an intensity (pressure) of a touch, and/or a digitizer that detects a magnetic field type stylus pen.

In an embodiment, the audio modules 203, 204, and 207 (e.g., the audio module 170 of FIG. 1) may include microphone holes 203 and 204, and speaker holes 207.

In an embodiment, the microphone holes 203 and 204 may include a first microphone hole 203 formed in a partial region of the third surface 200C and a second microphone hole 204 formed in a partial region of the second surface 200B. A microphone (not illustrated) for obtaining an external sound may be disposed in the microphone holes 203 and 204. The microphone may include a plurality of microphones to sense a direction of the sound.

In an embodiment, the second microphone hole 204 formed in the partial region of the second surface 200B may be disposed adjacent to the camera modules 205, 212, and 213. For example, the second microphone hole 204 may obtain a sound according to an operation of the camera modules 205, 212, and 213. However, it is not limited thereto.

In an embodiment, the speaker hole 207 may include an external speaker hole 207 and a call receiver hole (not illustrated). The external speaker hole 207 may be formed on a portion of the third surface 200C of the electronic device 200. In an embodiment, the external speaker hole 207 may be implemented as one hole with the microphone hole 203. Although not illustrated, the call receiver hole (not illustrated) may be formed on another portion of the third surface 200C. For example, the call receiver hole may be formed on an opposite side of the external speaker hole 207 on the third surface 200C. For example, based on an illustration of FIG. 2, the external speaker hole 207 may be formed on the third surface 200C corresponding to a lower end of the electronic device 200, and the call receiver hole may be formed on the third surface 200C corresponding to an upper end of the electronic device 200. However, it is not limited thereto, and in an embodiment, the call receiver hole may be formed at a position other than the third surface 200C. For example, the call receiver hole may be formed by a space separated between the front plate 202 (or the display 201) and the side bezel structure 218.

In an embodiment, the electronic device 200 may include at least one speaker (not illustrated) configured to output a sound to an outside of the housing 230 through the external speaker hole 207 and/or the call receiver hole (not illustrated).

In an embodiment, the sensor module (not illustrated) (e.g., the sensor module 176 of FIG. 1) may generate an electrical signal or a data value corresponding to an operating state inside the electronic device 200 or an external environmental state. For example, the sensor module may include at least one of a proximity sensor, an HRM sensor, a fingerprint sensor, a gesture sensor, a gyro sensor, a barometric sensor, a magnetic sensor, an acceleration sensor, a grip sensor, a color sensor, an infrared (IR) sensor, a biometric sensor, a temperature sensor, a humidity sensor, or an illuminance sensor.

In an embodiment, the camera modules 205, 212, and 213 (e.g., the camera module 180 of FIG. 1) may include the first camera module 205 disposed to face the first surface 200A of the electronic device 200, a second camera module 212 disposed to face the second surface 200B, and a flash 213.

In an embodiment, the second camera module 212 may include a plurality of cameras (e.g., a dual camera, a triple camera, or a quad camera). However, the second camera module 212 is not necessarily limited to including the plurality of cameras, and may include one camera.

In an embodiment, the first camera module 205 and the second camera module 212 may include one or more lenses, an image sensor, and/or an image signal processor.

In an embodiment, the flash 213 may include, for example, a light-emitting diode or a xenon lamp. In an embodiment, two or more lenses (infrared camera, wide-angle and telephoto lenses) and image sensors may be disposed on a surface of the electronic device 200.

In an embodiment, the key input device 217 (e.g., the input module 150 of FIG. 1) may be disposed on the third surface 200C of the electronic device 200. In an embodiment, the electronic device 200 may not include some or all of the key input device 217, and the key input device 217 that is not included may be implemented in another form, such as a soft key, on the display 201.

In an embodiment, the connector hole 208 may be formed on the third surface 200C of the electronic device 200 to receive a connector of the external device. A connection terminal (e.g., the connection terminal 178 of FIG. 1) electrically connected with the connector of the external device may be disposed in the connector hole 208. The electronic device 200 according to an embodiment may include an interface module (e.g., the interface 177 of FIG. 1) for processing an electrical signal transmitted and received through the connection terminal.

In an embodiment, the electronic device 200 may include the light-emitting element (not illustrated). For example, the light-emitting element (not illustrated) may be disposed on the first surface 200A of the housing 230. The light-emitting element (not illustrated) may provide state information of the electronic device 200 in an optical form. In an embodiment, the light-emitting element (not illustrated) may provide a light source linked with an operation of the first camera module 205. For example, the light-emitting element (not illustrated) may include an LED, an IR LED, and/or a xenon lamp.

FIG. 3 is an exploded perspective view of an electronic device according to an embodiment.

Hereinafter, an overlapping description of a configuration having the same reference numeral as the above-described configuration may be omitted.

Referring to FIG. 3, an electronic device 200 according to an embodiment may include a frame 240, a first printed circuit board 250, a second printed circuit board 252, a cover plate 260, and a battery 270.

In an embodiment, the frame 240 may include a sidewall 241 forming an exterior (e.g., the third surface 200C of FIG. 2) of the electronic device 200 and a supporting portion 243 extending inward from the sidewall 241. In an embodiment, the frame 240 may be disposed between a display 201 and a rear plate 211. In an embodiment, the sidewall 241 of the frame 240 may surround a space between the rear plate 211 and a front plate 202 (and/or the display 201), and the supporting portion 243 of the frame 240 may extend from the sidewall 241 within the space.

In an embodiment, the frame 240 may support or receive other components included in the electronic device 200. For example, the display 201 may be disposed on a surface of the frame 240 facing a direction (e.g., a +z direction), and the display 201 may be supported by a supporting portion 243 of the frame 240. In an embodiment, the first printed circuit board 250, the second printed circuit board 252, the battery 270, and a second camera module 212 may be disposed on another surface of the frame 240 facing an opposite direction (e.g., a -z direction) of the direction. The first printed circuit board 250, the second printed circuit board 252, the battery 270, and the second camera module 212 may be respectively seated in a recess defined by the sidewall 241 and/or the supporting portion 243 of the frame 240.

In an embodiment, the first printed circuit board 250, the second printed circuit board 252, and the battery 270 may be coupled to the frame 240, respectively. For example, the first printed circuit board 250 and the second printed circuit board 252 may be fixedly disposed on the frame 240 through a coupling member such as a screw. For example, the battery 270 may be fixedly disposed on the frame 240 through an adhesive member (e.g., a double-sided tape). However, it is not limited by the above-described example.

In an embodiment, the cover plate 260 may be disposed between the first printed circuit board 250 and the rear plate 211. In an embodiment, the cover plate 260 may be disposed on the first printed circuit board 250. For example, the cover plate 260 may be disposed on a surface of the first printed circuit board 250 facing the -z direction.

In an embodiment, the cover plate 260 may at least partially overlap the first printed circuit board 250 with respect to a z-axis. In an embodiment, the cover plate 260 may cover at least a partial region of the first printed circuit board 250. Accordingly, the cover plate 260 may protect the first printed circuit board 250 from a physical impact or prevent a connector coupled to the first printed circuit board 250 from being separated.

In an embodiment, the cover plate 260 may be fixedly disposed on the first printed circuit board 250 through the coupling member (e.g., the screw), or may be coupled to the frame 240 together with the first printed circuit board 250 through the coupling member.

In an embodiment, the display 201 may be disposed between the frame 240 and the front plate 202. For example, the front plate 202 may be disposed on a side (e.g., the +z direction) of the display 201, and the frame 240 may be disposed on another side (e.g., the -z direction).

In an embodiment, the front plate 202 may be coupled to the display 201. For example, the front plate 202 and the display 201 may be adhered to each other through an optical adhesive member (e.g., an optically clear adhesive (OCA) or an optically clear resin (OCR)) interposed therebetween.

In an embodiment, the front plate 202 may be coupled to the frame 240. For example, the front plate 202 may include an outer portion extending outside the display 201 when viewed in the z-axis direction, and may be attached to the frame 240 through the adhesive member (e.g., the double-sided tape) disposed between the outer portion of the front plate 202 and the frame 240 (e.g., the sidewall 241). However, it is not limited by the above-described example.

In an embodiment, a processor (e.g., the processor 120 of FIG. 1), memory (e.g., the memory 130 of FIG. 1), and/or an interface (e.g., the interface 177 of FIG. 1) may be mounted on the first printed circuit board 250 and/or the second printed circuit board 252. The processor may include, for example, one or more of a central processing unit, an application processor, a graphic processing unit, an image signal processor, a sensor hub processor, or a communication processor. The memory may include, for example, a volatile memory or a non-volatile memory. The interface may include, for example, a high definition multimedia interface (HDMI), a universal serial bus (USB) interface, an SD card interface, and/or an audio interface. The interface may electrically or physically connect the electronic device 200 to an external electronic device, and may include a USB connector, an SD card/MMC connector, or an audio connector. In an embodiment, the first printed circuit board 250 and the second printed circuit board 252 may be operatively or electrically connected with each other through a connection member (e.g., a flexible printed circuit board).

In an embodiment, the battery 270 (e.g., the battery 189 of FIG. 1) may supply power to at least one component of the electronic device 200. For example, the battery 270 may include a rechargeable secondary battery or a fuel cell. At least a portion of the battery 270 may be disposed on substantially the same plane as the first printed circuit board 250 and/or the second printed circuit board 252.

The electronic device 200 according to an embodiment may include an antenna module (not illustrated) (e.g., the antenna module 197 of FIG. 1). In an embodiment, the antenna module may be disposed between the rear plate 211 and the battery 270. The antenna module may include, for example, a near field communication (NFC) antenna, a wireless charging antenna, and/or a magnetic secure transmission (MST) antenna. The antenna module may perform, for example, short-range communication with an external device or wirelessly transmit and receive power to and from the external device.

In an embodiment, the first camera module 205 (e.g., a front camera) may be disposed on at least a portion (e.g., the supporting portion 243) of the frame 240 so that a lens may receive external light through a partial region (e.g., a camera region 237) of the front plate 202 (e.g., the front surface 200A of FIG. 2).

In an embodiment, the second camera module 212 (e.g., a rear camera) may be disposed between the frame 240 and the rear plate 211. In an embodiment, the second camera module 212 may be electrically connected to the first printed circuit board 250 through a connection member (e.g., the connector). In an embodiment, the second camera module 212 may be disposed so that a lens may receive the external light through a camera region 284 of the rear plate 211 of the electronic device 200.

In an embodiment, the camera region 284 may be formed on a surface (e.g., the rear surface 200B of FIG. 2) of the rear plate 211. In an embodiment, the camera region 284 may be formed to be at least partially transparent so that external light may be incident on the lens of the second camera module 212. In an embodiment, at least a portion of the camera region 284 may protrude from the surface of the rear plate 211 by a predetermined height. However, it is not limited thereto, and in an embodiment, the camera region 284 may form substantially the same plane as the surface of the rear plate 211.

In an embodiment, a housing (e.g., the housing 230 of FIG. 2) of the electronic device 200 may mean a configuration or a structure forming at least a portion of the exterior of the electronic device 200. In this respect, at least a portion of the front plate 202, the frame 240, and/or the rear plate 211 forming the exterior of the electronic device 200 may be referred to as the housing 230 of the electronic device 200.

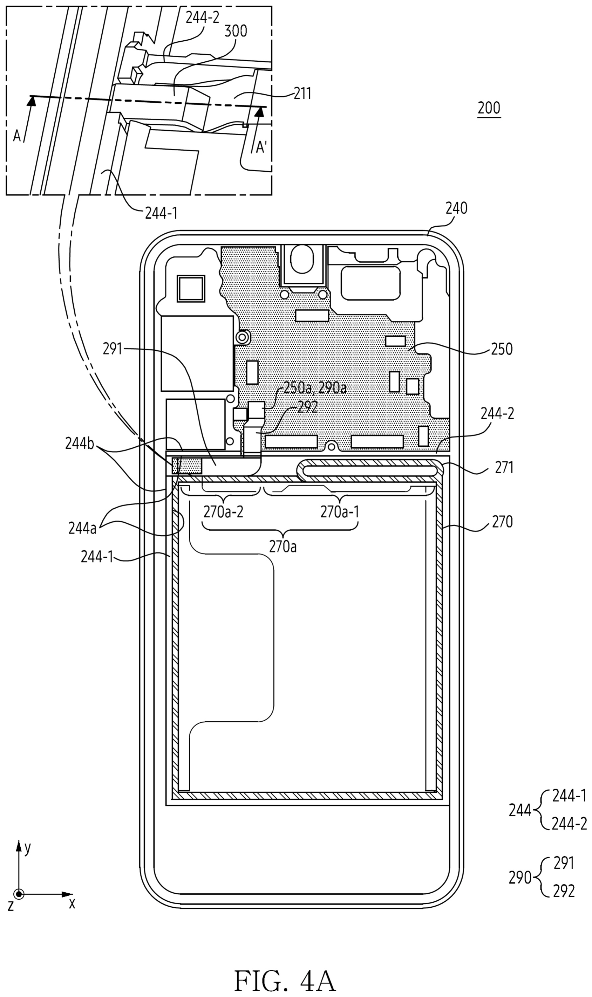

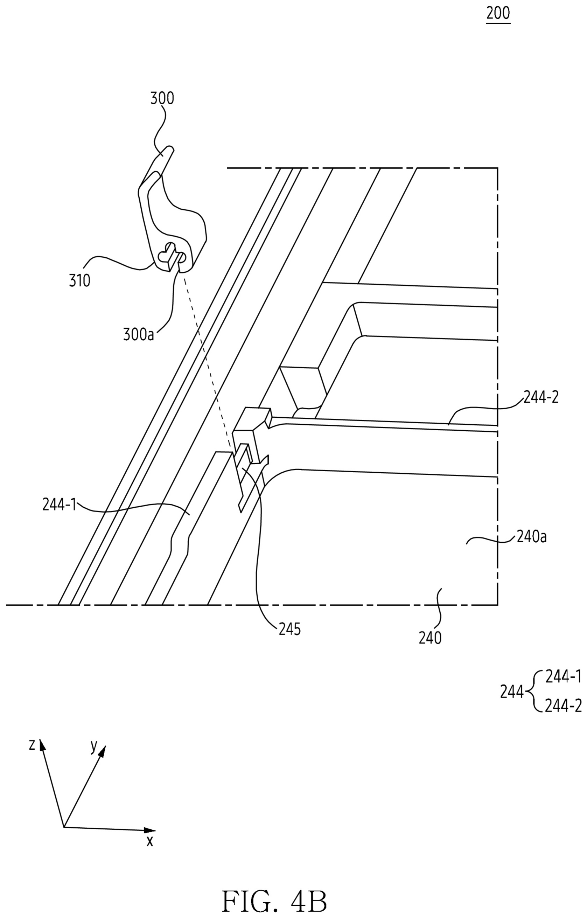

FIG. 4A is a top plan view of an exemplary electronic device according to an embodiment, and FIG. 4B is an exploded perspective view illustrating an example of a method in which an exemplary supporting member and a frame according to an embodiment are coupled to each other.

Referring to FIGS. 4A and 4B, an electronic device 200 according to an embodiment may include a frame 240, a first printed circuit board 250, a battery 270, a flexible printed circuit board 290, and/or a supporting member 300. Hereinafter, a structure of an embodiment will be described with respect to the battery 270, but the battery 270 is merely a non-limiting example. For example, in a structure according to an embodiment to be described later, the battery 270 may be replaced with another electronic component connected to the flexible printed circuit board 290.

According to an embodiment, the frame 240 may support components of the electronic device 200. The frame 240 may provide a space in which the components of the electronic device 200 may be disposed. The battery 270 may be disposed within the frame 240. For example, the battery 270 may be disposed on a first surface 240a of the frame 240. The first printed circuit board 250 may be disposed within the frame 240. For example, the first printed circuit board 250 may be spaced apart from the battery 270 within the frame 240. According to an embodiment, the frame 240 may include at least one partition wall 244 that divides a space within the frame 240. The at least one partition wall 244 may distinguish a space within the frame 240 in which the battery 270 is disposed and a space within the frame 240 in which the first printed circuit board 250 is disposed. The at least one partition wall 244 may enclose (or surround) the battery 270. For example, an inner surface 244a of the at least one partition wall 244 may face the battery 270. For example, an outer surface 244b of the at least one partition wall 244 may be opposite to the inner surface 244a of the at least one partition wall 244. The at least one partition wall 244 may protrude from the first surface 240a. For example, the at least one partition wall 244 may extend from the first surface 240a along a direction (e.g., a +z direction) in which the first surface 240a faces. The at least one partition wall 244 may be disposed along peripheries of the first surface 240a. For example, the at least one partition wall 244 may enclose (or surround) a periphery of the first surface 240a.

According to an embodiment, the at least one partition wall 244 may include a first partition wall 244-1 and a second partition wall 244-2. The first partition wall 244-1 may extend along a first direction (e.g., a +y direction). The second partition wall 244-2 may extend along a second direction (e.g., a +x direction) that is distinct from the first direction (e.g., the +y direction). The second direction (e.g., the +x direction) may be perpendicular to the first direction (e.g., the +y direction). The second partition wall 244-2 may be disposed between the battery 270 and the first printed circuit board 250.

According to an embodiment, the at least one partition wall 244 may include a first coupling portion 245. For example, the first coupling portion 245 may be included in the first partition wall 244-1, but is not limited thereto. For example, the first coupling portion 245 may be also included in the second partition wall 244-2. The first coupling portion 245 may be coupled to the supporting member 300. The first coupling portion 245 may be in contact with the supporting member 300. For example, the first coupling portion 245 may be enclosed (or surrounded) by the supporting member 300. The first coupling portion 245 may have a shape corresponding to a shape of the supporting member 300. As the first coupling portion 245 has the shape corresponding to the shape of the supporting member 300, the first coupling portion 245 may be engaged with the supporting member 300.

According to an embodiment, the first printed circuit board 250 may form (or provide) an electrical connection between electronic components in the electronic device 200. For example, a processor (e.g., the processor 120 of FIG. 1) may be disposed on the first printed circuit board 250. The first printed circuit board 250 may be disposed on the frame 240. For example, the first printed circuit board 250 may be spaced apart from the battery 270 along the first direction (e.g., the +y direction). According to an embodiment, the first printed circuit board 250 may include a first connector 250a. The first connector 250a may be electrically connected to the flexible printed circuit board 290. For example, the first connector 250a may be one of a socket connector and a plug connector of a board to board connector (a btob connector).

According to an embodiment, the battery 270 may be received within the frame 240. The battery 270 may be in contact with the first surface 240a. The battery 270 may be disposed in the at least one partition wall 244. The battery 270 may be received within the at least one partition wall 244. For example, the battery 270 may be enclosed (or surrounded) by the at least one partition wall 244. According to an embodiment, the battery 270 may include a protection circuit module (PCM) 271 (or a battery protection module). The protection circuit module 271 may reduce a probability that the battery 270 is over charged. The protection circuit module 271 may reduce a probability that the battery 270 is over discharged. The protection circuit module 271 may cut off an overcurrent transmitted to the battery 270. The protection circuit module 271 may be disposed between a lateral side 270a of the battery 270 and the at least one partition wall 244. For example, the lateral side 270a of the battery 270 may face the first direction (e.g., the +y direction), which is a direction facing the first printed circuit board 250. The lateral side 270a of the battery 270 may face the second partition wall 244-2. The protection circuit module 271 may be disposed along a portion 270a-1 of the lateral side 270a. For example, a size of the protection circuit module 271 may be smaller than a size of the lateral side 270a of the battery 270.

According to an embodiment, the flexible printed circuit board 290 may electrically connect the battery 270 to the first printed circuit board 250. For example, the flexible printed circuit board 290 may extend from the battery 270 to the first printed circuit board 250. For example, the flexible printed circuit board 290 may include a bending portion 291 and a connector portion 292. The bending portion 291 may have a bent shape. For example, the bending portion 291 may be defined (or formed) as a portion of the flexible printed circuit board 290 is deformed to be bent with respect to another portion of the flexible printed circuit board 290. For example, when the electronic device 200 is manufactured, the battery 270 may be manufactured in a form including the flexible printed circuit board 290 and then disposed in the frame 240. In order for the battery 270 to be disposed within various spaces within the frame 240, the flexible printed circuit board 290 may be formed (or manufactured) to have a relatively long length. Since the flexible printed circuit board 290 has the relatively long length, the flexible printed circuit board 290 may be disposed within the frame 240 after being bent. Since the flexible printed circuit board 290 is disposed in the frame 240 after being bent, the bending portion 291 may be formed. For example, the bending portion 291 may be bent to have a curvature, but is not limited thereto. For example, the bending portion 291 may be bent substantially vertically. For example, the bending portion 291 may be disposed (or received) in the partition wall 244. For example, the bending portion 291 may be connected to the battery 270 disposed (or received) in the partition wall 244. The connector portion 292 may be connected to the bending portion 291. The connector portion 292 may extend from the bending portion 291 to the first printed circuit board 250. The connector portion 292 may be disposed outside the at least one partition wall 244. For example, a boundary between the bending portion 291 and the connector portion 292 may correspond to a position of the second partition wall 244-2. The connector portion 292 may be positioned on the first printed circuit board 250 by being disposed outside the at least one partition wall 244. The connector portion 292 may include a second connector 290a. The second connector 290a may be coupled to the first connector 250a of the first printed circuit board 250. The second connector 290a may electrically connect the battery 270 and the first printed circuit board 250 by being coupled to the first connector 250a. For example, the second connector 290a may be one of the socket connector and the plug connector of the board to board connector (the btob connector). According to an embodiment, the flexible printed circuit board 290 may be integrally formed with the battery 270, but is not limited thereto.

According to an embodiment, the supporting member 300 may support the flexible printed circuit board 290. The supporting member 300 may press the flexible printed circuit board 290. For example, the supporting member 300 may apply a force in a third direction (e.g., a -z direction) toward the first surface 240a to the bending portion 291 of the flexible printed circuit board 290. The supporting member 300 may be coupled to the frame 240. For example, the supporting member 300 may include a second coupling portion 310 corresponding to the first coupling portion 245 of the at least one partition wall 244. The second coupling portion 310 may be coupled to the first coupling portion 245. The second coupling portion 310 may be in contact with the first coupling portion 245. For example, the second coupling portion 310 may enclose (or surround) the first coupling portion 245. A shape of the second coupling portion 310 may correspond to a shape of the first coupling portion 245. As the shape of the second coupling portion 310 corresponds to the shape of the first coupling portion 245, the second coupling portion 310 may be engaged with the first coupling portion 245. According to an embodiment, the supporting member 300 may be separable from the at least one partition wall 244 of the frame 240. For example, an end 300a of the supporting member 300 may be opened toward an outside of the supporting member 300. For example, the second coupling portion 310 may be opened toward the outside of the supporting member 300. As the end 300a of the supporting member 300 is opened, the first coupling portion 245 may pass through the end 300a of the supporting member 300 while the supporting member 300 is coupled to the at least one partition wall 244. As the first coupling portion 245 passing through the end 300a of the supporting member 300 engages with the second coupling portion 310, the coupling of the at least one partition wall 244 of the supporting member 300 may be completed. According to an embodiment, the supporting member 300 may be described as a flexible printed circuit board (FPCB) holder. For example, the supporting member 300 may press the flexible printed circuit board 290 to reduce a lifting thereof. According to an embodiment, the supporting member 300 supporting the flexible printed circuit board 290 may be described as the supporting member 300 pressing to maintain the bent shape of the flexible printed circuit board 290.

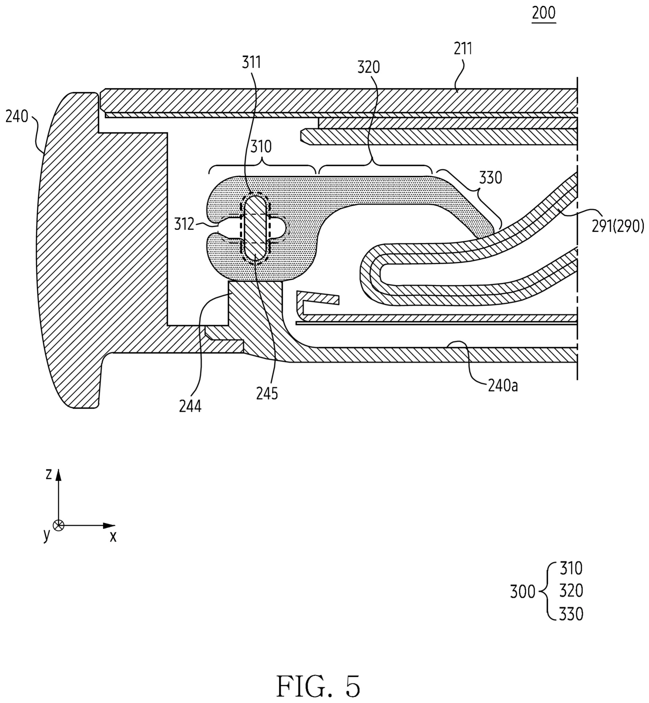

According to an embodiment, the supporting member 300 may be movable with respect to the at least one partition wall 244. For example, the supporting member 300 may be movable with respect to the at least one partition wall 244 while being coupled to the at least one partition wall 244. For example, the supporting member 300 may be rotatable with respect to the at least one partition wall 244. As the supporting member 300 moves with respect to the at least one partition wall 244, a position of the supporting member 300 may be changed to a first position in contact with the bending portion 291 of the flexible printed circuit board 290. When the position of the supporting member 300 is the first position, the supporting member 300 may be positioned on the bending portion 291. When the position of the supporting member 300 is the first position, the supporting member 300 may apply a force in the third direction (e.g., the -z direction) toward the first surface 240a to the bending portion 291 by contacting the bending portion 291. When the position of the supporting member 300 is the first position, the supporting member 300 may be spaced apart from the protection circuit module 271. For example, when the position of the supporting member 300 is the first position, the supporting member 300 may be positioned between another portion 270a-2 of the lateral side 270a of the battery 270 and the at least one partition wall 244. The other portion 270a-2 of the lateral side 270a may not correspond to the protection circuit module 271, unlike the portion 270a-1 of the lateral side 270a corresponding to the protection circuit module 271. When the position of the supporting member 300 is the first position, a reaction force by the bending portion 291 of the flexible printed circuit board 290 transmitted to other components in the electronic device 200 may be reduced. For example, the reduction of the reaction force by the bending portion 291 of the flexible printed circuit board 290 may be described with reference to FIG. 5.

FIG. 5 is a cross-sectional view illustrating an example cut along line A-A' of FIG. 4A of an exemplary electronic device according to an embodiment.

FIG. 5 is a cross-sectional view illustrating an example in which an exemplary electronic device is cut along line A-A' of FIG. 4A according to an embodiment.

Referring to FIG. 5, a rear plate 211 may be disposed on a frame 240. The rear plate 211 may be disposed on at least one partition wall 244. For example, the rear plate 211 may be spaced apart from the partition wall 244 along a fourth direction (e.g., a +z direction) in which a first surface 240a faces.

According to an embodiment, when a position of a supporting member 300 is a first position, a bending portion 291 may be pressed by the supporting member 300. A flexible printed circuit board 290 may be spaced apart from the rear plate 211 by the supporting member 300. For example, the bending portion 291 may be bent under the rear plate 211. Since the bending portion 291 is formed by a deformation of the flexible printed circuit board 290, a reaction force by the bending portion 291 may be transmitted to other components in an electronic device 200. For example, in a case that the reaction force by the bending portion 291 is transmitted to the rear plate 211, the rear plate 211 may be separated from the frame 240. The electronic device 200 according to an embodiment may provide a structure capable of maintaining a position of the flexible printed circuit board 290 disposed in the electronic device 200 by the supporting member 300 pressing the bending portion 291. As the position of the flexible printed circuit board 290 is maintained, damage in the electronic device 200 may be reduced.

According to an embodiment, the supporting member 300 may include an extending portion 320 and a pressing portion 330. The extending portion 320 may be connected to a second coupling portion 310. The extending portion 320 may extend from the second coupling portion 310 to the pressing portion 330. The extending portion 320 may extend linearly. For example, when the position of the supporting member 300 is the first position, the extending portion 320 may have a shape extending along a second direction (e.g., a +x direction). The pressing portion 330 may be connected to the extending portion 320. The pressing portion 330 may be bent with respect to the extending portion 320. For example, when the position of the supporting member 300 is the first position, the pressing portion 330 may be bent with respect to the extending portion 320 to face the first surface 240a.

According to an embodiment, a portion of the supporting member 300 may be parallel to the first surface 240a when the position of the supporting member 300 is the first position. For example, the extending portion 320 of the supporting member 300 may be parallel to the first surface 240a when the position of the supporting member 300 is the first position.

According to an embodiment, the first position of the supporting member 300 may be maintained by an engagement of a first coupling portion 245 and the second coupling portion 310. For example, a cross section of the first coupling portion 245 may have a shape extending along a third direction (e.g., a -z direction) toward the first surface 240a. The second coupling portion 310 may include a first opening 311 and a second opening 312. Shapes of each of the first opening 311 and the second opening 312 may correspond to the shape of the first coupling portion 245. For example, when the position of the supporting member 300 is the first position, the first opening 311 may have a shape extending along the third direction (e.g., the -z direction). The second opening 312 may intersect the first opening 311. For example, the second opening 312 may extend across the first opening 311. For example, when the position of the supporting member 300 is the first position, the second opening 312 may have a shape extending along a second direction (e.g., a +x direction) perpendicular to the third direction (e.g., the -z direction). As the shapes of each of the first opening 311 and the second opening 312 correspond to the shape of the first coupling portion 245, the position of the supporting member 300 may be maintained. For example, the first coupling portion 245 may be received within the first opening 311 when the position of the supporting member 300 is the first position. For example, when the position of the supporting member 300 is the first position, the first coupling portion 245 may be positioned (or disposed) in the first opening 311. When the position of the supporting member 300 is the first position, the first coupling portion 245 may be engaged with the second coupling portion 310 within the first opening 311.

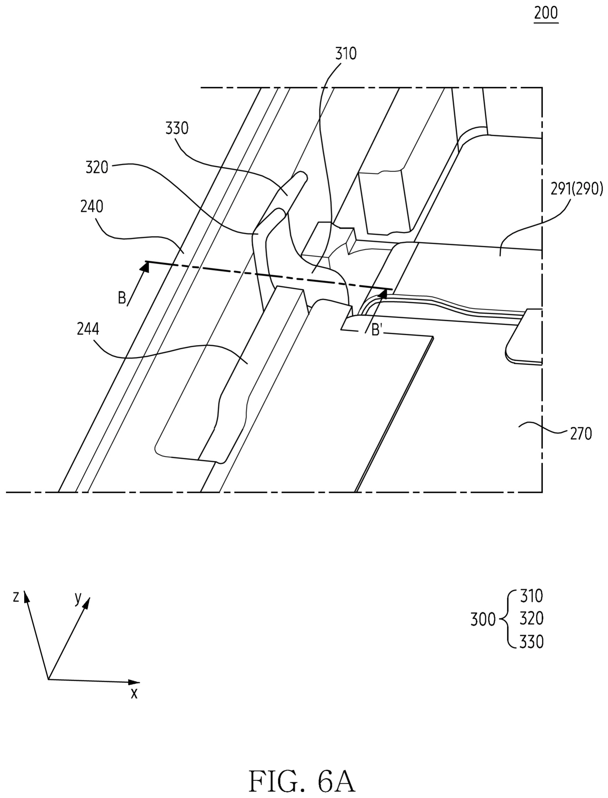

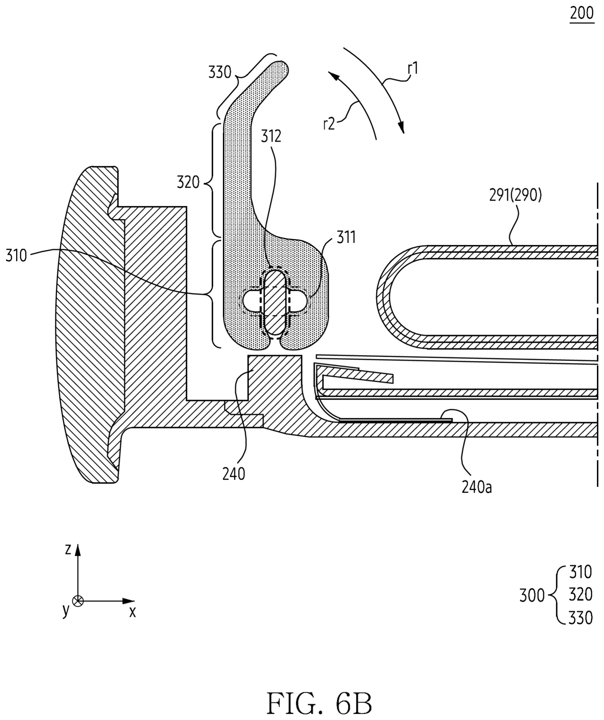

For example, as the supporting member 300 moves with respect to the at least one partition wall 244, the position of the supporting member 300 may be changed from the first position to a second position. For example, a description of the second position of the supporting member 300 may be described with reference to FIGS. 6A and 6B.

FIG. 6A is an enlarged perspective view of an exemplary electronic device according to an embodiment, and FIG. 6B is a cross-sectional view illustrating an example in which an exemplary electronic device is cut along line B-B' of FIG. 6A according to an embodiment.

FIGS. 6A and 6B may indicate when a position of a supporting member 300 is a second position.

Referring to FIGS. 6A and 6B, when the position of the supporting member 300 is the second position, the supporting member 300 may be spaced apart from a flexible printed circuit board 290. When the position of the supporting member 300 is the second position, the supporting member 300 may be spaced apart from a bending portion 291. For example, when the position of the supporting member 300 is the second position, the supporting member 300 may not be in contact with the flexible printed circuit board 290. For example, when the position of the supporting member 300 is the second position, a pressing portion 330 may be spaced apart from the bending portion 291. When the position of the supporting member 300 is the second position, a portion of the supporting member 300 may be disposed outside at least one partition wall 244. For example, when the position of the supporting member 300 is the second position, the pressing portion 330 may be disposed outside the at least one partition wall 244.

According to an embodiment, the portion of the supporting member 300 may be perpendicular to a first surface 240a when the position of the supporting member 300 is the second position. For example, when the position of the supporting member 300 is the second position, an extending portion 320 of the supporting member 300 may be perpendicular to the first surface 240a.

According to an embodiment, the second position of the supporting member 300 may be maintained by an engagement of a first coupling portion 245 and a second coupling portion 310. For example, when the position of the supporting member 300 is the second position, the first coupling portion 245 may be received within a second opening 312. When the position of the supporting member 300 is the second position, the first coupling portion 245 may be positioned (or disposed) within the second opening 312. As the first coupling portion 245 is engaged with the second coupling portion 310 within the second opening 312, the second position of the supporting member 300 may be maintained.

According to an embodiment, as the supporting member 300 rotates in a first rotational direction r1 with respect to the at least one partition wall 244 while being coupled to the at least one partition wall 244, the position of the supporting member 300 may be changed from the second position to a first position. As the supporting member 300 rotates in a second rotational direction r2 opposite to the first rotational direction r1 with respect to the at least one partition wall 244 while being coupled to the at least one partition wall 244, the position of the supporting member 300 may be changed from the first position to the second position. For example, in order for the electronic device 200 to be discarded, separation of a frame 240 and a battery 270 may be required. The electronic device 200 according to an embodiment may provide a structure in which the battery 270 and the frame 240 are easily separated by the supporting member 300 that is movable with respect to the at least one partition wall 244 (or the frame 240). For example, when the electronic device 200 is repaired, the battery 270 may be replaced. Since the supporting member 300 is movable with respect to the at least one partition wall 244, the battery 270 may be easily separated from the frame 240. For example, when replacing the battery 270, as the supporting member 300 rotates in the second rotational direction r2, the position of the supporting member 300 may be changed from the first position to the second position. After the battery 270 is replaced, as the supporting member 300 rotates in the first rotational direction r1, the position of the supporting member 300 may be changed from the second position to the first position. As the position of the supporting member 300 changes from the second position to the first position, the supporting member 300 may press the flexible printed circuit board 290 connected to the battery 270 in a third direction (e.g., a -z direction) toward the first surface 240a.

As described above, the electronic device 200 according to an embodiment may provide a structure capable of reducing damage due to a reaction force of the flexible printed circuit board 290 by the supporting member 300 configured to press the flexible printed circuit board 290. The electronic device 200 according to an embodiment may provide a structure in which the battery 270 and the frame 240 are easily separated or assembled, since the supporting member 300 is movable with respect to the at least one partition wall 244 (or the frame 240).

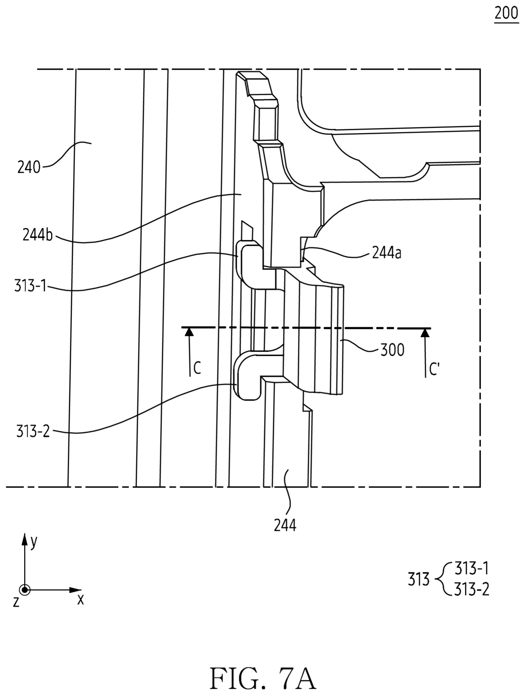

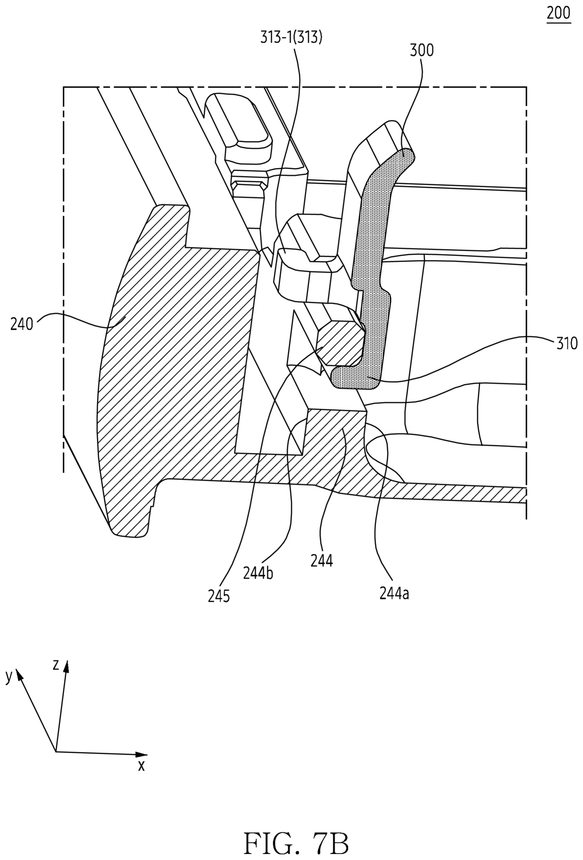

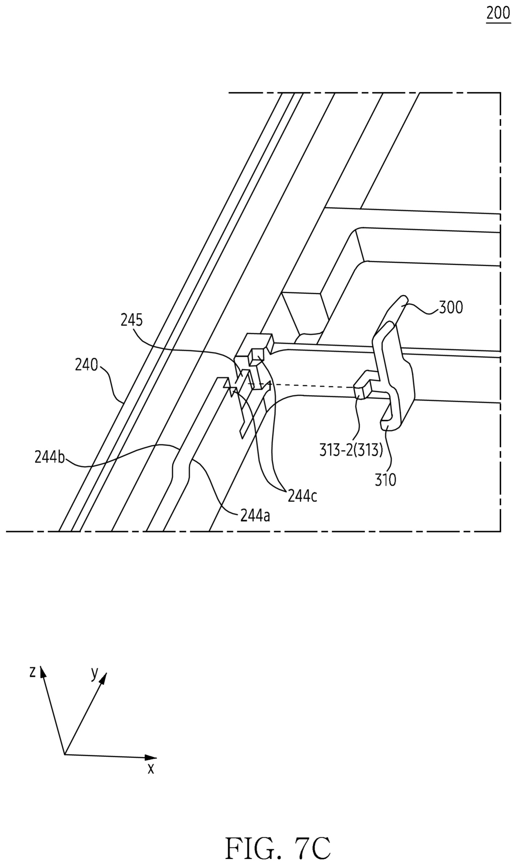

FIG. 7A is a perspective view of an exemplary electronic device according to an embodiment, FIG. 7B is a partial perspective view illustrating an example in which an exemplary electronic device is cut along line C-C' of FIG. 7A according to an embodiment, and FIG. 7C is an exploded perspective view illustrating an example of a method in which an exemplary supporting member and a frame are coupled to each other according to an embodiment.

FIGS. 7A and 7B may indicate when a position of a supporting member 300 is a second position. Since the supporting member 300 of FIGS. 7A, 7B, and 7C may be the supporting member 300 of which a portion of the structure is changed in the supporting member 300 of FIGS. 4A and 4B, an overlapping description thereof will be omitted.

Referring to FIGS. 7A, 7B, and 7C, according to an embodiment, a shape of a cross section of a first coupling portion 245 may have a polygonal shape. A shape of a second coupling portion 310 may correspond to the first coupling portion 245. The second coupling portion 310 may be opened toward an outer surface 244b of at least one partition wall 244.

According to an embodiment, the second coupling portion 310 may include one or more coupling protrusions 313. Each of the one or more coupling protrusions 313 may have a shape extending from the second coupling portion 310. The one or more coupling protrusions 313 may maintain the position of the supporting member 300 by contacting the at least one partition wall 244. As the position of the supporting member 300 is changed to one of a first position and the second position, one or more protrusions 313 may be contacted on one of an inner surface 244a and an outer surface 244b of the partition wall. For example, when the position of the supporting member 300 is the second position, the one or more coupling protrusions 313 may be contacted on the outer surface 244b of the at least one partition wall 244.

Referring to FIG. 7C, according to an embodiment, the supporting member 300 may be separably coupled to the at least one partition wall 244 by deformation of the one or more coupling protrusions 313. For example, before the supporting member 300 is coupled to the at least one partition wall 244, the one or more coupling protrusions 313 may be deformed by an external force. For example, in a case that the one or more coupling protrusions 313 include a plurality of coupling protrusions 313-1 and 313-2, the plurality of coupling protrusions 313-1 and 313-2 may be deformed in a direction of getting closer to each other. After the second coupling portion 310 of the supporting member 300 is in contact with the first coupling portion 245 of the at least one partition wall 244, the external force applied to the one or more coupling protrusions 313 may be removed. As the external force is removed, the one or more protrusions 313 may be contacted on the outer surface 244b of the partition wall 244.

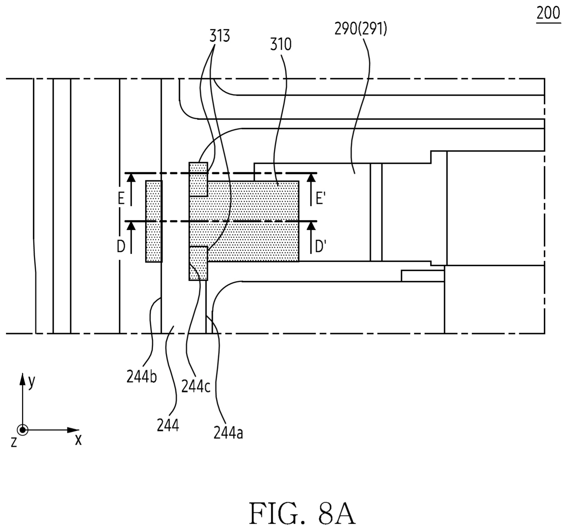

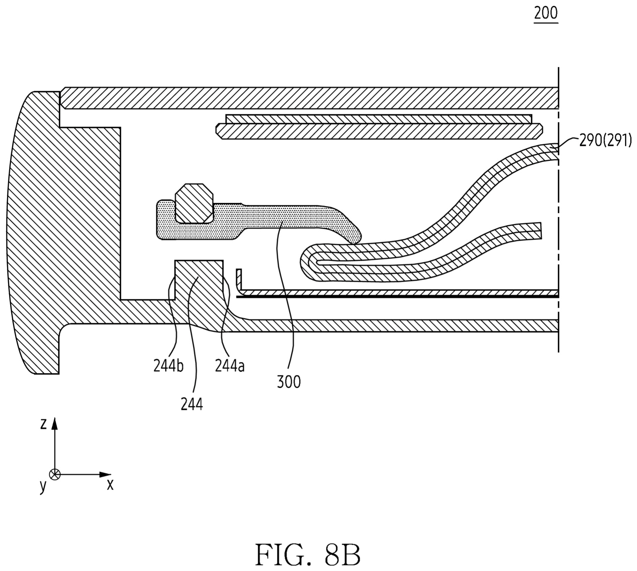

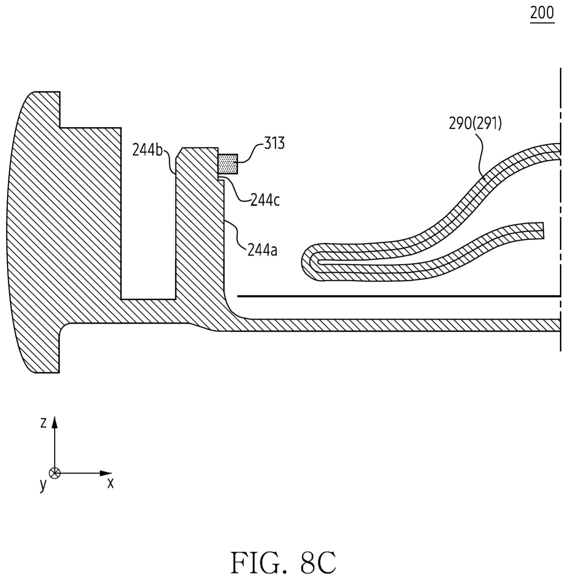

According to an embodiment, the partition wall 244 may include one or more grooves 244c. The one or more grooves 244c may be formed as the inner surface 244a of the at least one partition wall 244 is dent. The one or more grooves 244c may correspond to the one or more protrusions 313. The one or more grooves 244c may receive the one or more protrusions 313. For example, when the position of the supporting member 300 is the first position, the one or more protrusions 313 may be received in the one or more grooves 244c formed on the inner surface 244a of the at least one partition wall 244. For example, when the position of the supporting member 300 is the first position, a relationship between the one or more coupling protrusions 313 and the partition wall 244 may be described with reference to FIGS. 8A, 8B, and 8C.

FIG. 8A is a top plan view of an exemplary electronic device according to an embodiment, FIG. 8B is a cross-sectional view illustrating an example in which an exemplary electronic device is cut along line D-D' of FIG. 8A according to an embodiment, and FIG. 8C is a cross-sectional view illustrating an example in which an exemplary electronic device is cut along line E-E' of FIG. 8A according to an embodiment.

Referring to FIGS. 8A, 8B, and 8C, according to an embodiment, when a position of a supporting member 300 is a first position, the supporting member 300 may be contacted on a flexible printed circuit board 290. When the position of the supporting member 300 is the first position, the supporting member 300 may be contacted on a bending portion 291 of the flexible printed circuit board 290. When the position of the supporting member 300 is the first position, one or more coupling protrusions 313 may be contacted on an inner surface 244a of at least one partition wall 244. For example, one or more coupling protrusions 313 may be received within one or more coupling grooves 244c formed on the inner surface 244a of the at least one partition wall 244. As the one or more coupling protrusions 313 are contacted on the inner surface 244a of the partition wall 244, the first position of the supporting member 300 may be maintained.

As described above, the electronic device 200 according to an embodiment may provide a structure in which a battery 270 and a frame 240 may be easily separated or assembled since the one or more coupling protrusions 313 maintain the position of the supporting member 300 by contacting one of the inner surface 244a and an outer surface 244b of the partition wall 244.

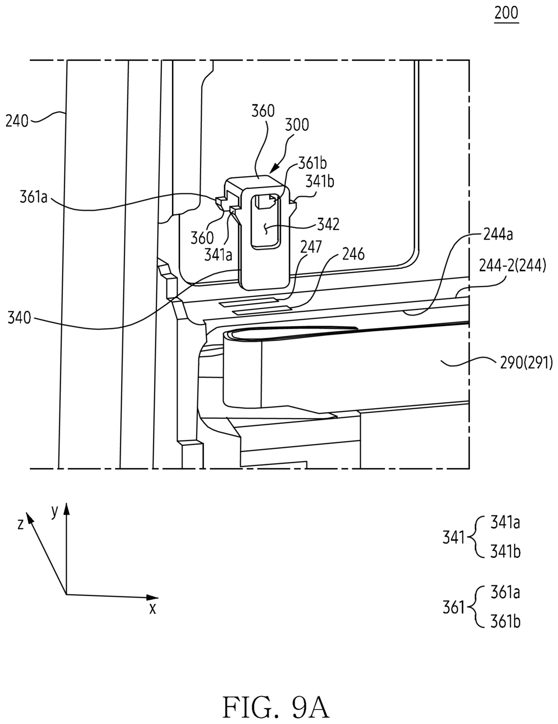

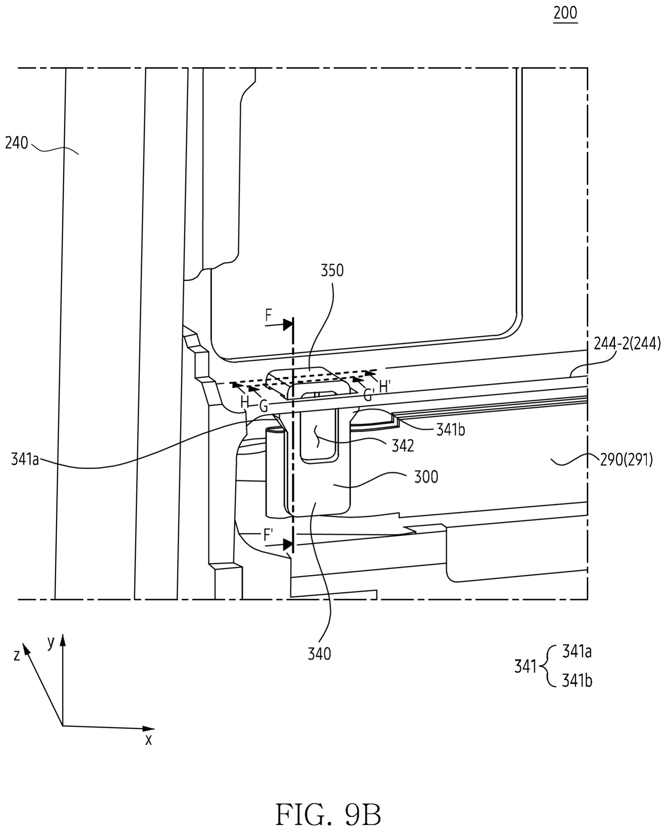

FIG. 9A illustrates an example of a method of coupling a frame with an exemplary supporting member according to an embodiment, and FIG. 9B is a perspective view of an exemplary electronic device according to an embodiment.

Since a supporting member 300 of FIGS. 9A and 9B may be the supporting member 300 of which a portion of the structure is changed in the supporting member 300 of FIGS. 4A and 4B, an overlapping description thereof will be omitted.

Referring to FIGS. 9A and 9B, according to an embodiment, a frame 240 may include a first through-hole 246 and a second through-hole 247. Each of the first through-hole 246 and the second through-hole 247 may penetrate at least one partition wall 244. For example, each of the first through-hole 246 and the second through-hole 247 may penetrate a second partition wall 244-2. The second through-hole 247 may be spaced apart (or separated) from the first through-hole 246. For example, the second through-hole 247 may be spaced apart from the first through-hole 246 along a third direction (e.g., a -z direction).

According to an embodiment, the supporting member 300 may be separable from the at least one partition wall 244. The supporting member 300 may include a first portion 340, a second portion 350, and/or a third portion 360.

According to an embodiment, the first portion 340 may press a flexible printed circuit board 290. The first portion 340 may pass through (or penetrate) the first through-hole 246. The first portion 340 may have a linearly extended shape. For example, the first portion 340 may have a shape extending along a first direction (e.g., a +y direction). According to an embodiment, the first portion 340 may include one or more first fastening protrusions 341 and an opening 342.

According to an embodiment, the one or more first fastening protrusions 341 may maintain a position of the supporting member 300. The one or more first fastening protrusions 341 may protrude in a direction toward an outside of the first portion 340. For example, the one or more first fastening protrusions 341 may have a shape inclined with respect to the first direction (e.g., the +y direction). However, it is not limited thereto. The one or more first fastening protrusions 341 may have a shape bent to have a curvature with respect to the first direction (e.g., the +y direction). The opening 342 may provide a space in which the first portion 340 may be deformed by an external force. For example, the one or more first fastening protrusions 341 may include a plurality of first fastening protrusions 341a and 341b. For example, in a case that the one or more first fastening protrusions 341 include the plurality of first fastening protrusions 341a and 341b, the opening 342 may provide a space in which the first portion 340 may be deformed so that the plurality of first fastening protrusions 341a and 341b move in a direction of getting closer to each other. The opening 342 may penetrate the first portion 340. For example, in a case that the one or more first fastening protrusions 341 include the plurality of first fastening protrusions 341a and 341b, the opening 342 may be disposed between the plurality of first fastening protrusions 341a and 341b.

According to an embodiment, the second portion 350 may connect the first portion 340 and the third portion 360. For example, the first portion 340 may be connected to an end of the second portion 350, and the third portion 360 may be connected to another end of the second portion 350 opposite to the end of the second portion 350. The second portion 350 may be disposed between the first portion 340 and the third portion 360. The second portion 350 may extend from the first portion 340 to the third portion 360. For example, the second portion 350 may extend from the first portion 340 to the third portion 360 along the third direction (e.g., the -z direction) perpendicular to the first direction (e.g., the +y direction).

According to an embodiment, the third portion 360 may support the supporting member 300 so that the supporting member 300 is not separated from the at least one partition wall 244 while the first portion 340 is inserted into the first through-hole 246. The third portion 360 may pass through (or penetrate) the second through-hole 247. The third portion 360 may have a linearly extended shape. For example, the third portion 360 may have a shape extending along the first direction (e.g., the +y direction).

According to an embodiment, the third portion 360 may include one or more second fastening protrusions 361. The one or more second fastening protrusions 361 may maintain the position of the supporting member 300. The one or more second fastening protrusions 361 may protrude in a direction toward an outside of the third portion 360. For example, the one or more second fastening protrusions 361 may have a shape inclined with respect to the first direction (e.g., the +y direction). However, it is not limited thereto. The one or more second fastening protrusions 361 may have a shape bent to have a curvature with respect to the first direction (e.g., the +y direction). According to an embodiment, the third portion 360 may have a shape opened toward an outside of the supporting member 300. For example, the third portion 360 may have a shape opened toward a battery 270 while the supporting member 300 is coupled to the at least one partition wall 244. For example, the opened shape may be a shape of a concave portion. For example, when describing with a C-shape, a convex portion may be described as a closed shape and/or a convex shape, and the concave portion may be described as the opened shape and/or a concave shape. As the third portion 360 has the opened shape, the third portion 360 may be deformed by the external force. For example, the one or more second fastening protrusions 361 may include a plurality of second fastening protrusions 361a and 361b. For example, in a case that the one or more second fastening protrusions 361 include the plurality of second fastening protrusions 361a and 361b, the plurality of second fastening protrusions 361a and 361b may be deformed in a direction of getting closer to each other by the external force.

According to an embodiment, the supporting member 300 may be coupled to the at least one partition wall 244 of the frame 240 to press the flexible printed circuit board 290. For example, the supporting member 300 may move from an outside of the at least one partition wall 244 in a direction (e.g., a -y direction) opposite to the first direction (e.g., the +y direction) in order to be coupled to the at least one partition wall 244. The supporting member 300 may slide with respect to the at least one partition wall 244 in a process of being coupled to the at least one partition wall 244. As the supporting member 300 slides with respect to the at least one partition wall 244, the first portion 340 may penetrate the first through-hole 246, and the third portion 360 may penetrate the second through-hole 247. As the first portion 340 penetrates the first through-hole 246, the one or more first fastening protrusions 341 may move from the outside of the at least one partition wall 244 to an inside of the at least one partition wall 244 by sliding with respect to the at least one partition wall 244. As the third portion 360 penetrates the second through-hole 247, the one or more second fastening protrusions 361 may move from the outside of the at least one partition wall 244 to the inside of the at least one partition wall 244 by sliding with respect to the at least one partition wall 244. As the one or more first fastening protrusions 341 and the one or more second fastening protrusions 361 are positioned on the inner surface 244a of the at least one partition wall 244, a combination of the supporting member 300 and the at least one partition wall 244 may be completed.

According to an embodiment, the supporting member 300 may move along the first direction (e.g., the +y direction) with respect to the at least one partition wall 244 to be separated from the at least one partition wall 244. The supporting member 300 may be deformed before being separated from the at least one partition wall 244. For example, the first portion 340 may be deformed by the external force so that the one or more first fastening protrusions 341 may move outside the first through-hole 246. For example, the third portion 360 may be deformed by the external force so that the one or more second fastening protrusions 361 may move outside the second through-hole 247. After the deformation, the supporting member 300 may slide in the first direction (e.g., the +y direction) with respect to the at least one partition wall 244. As the first portion 340 passes through the first through-hole 246 and the third portion 360 passes through the second through-hole 247, the separation between the supporting member 300 and the at least one partition wall 244 may be completed.

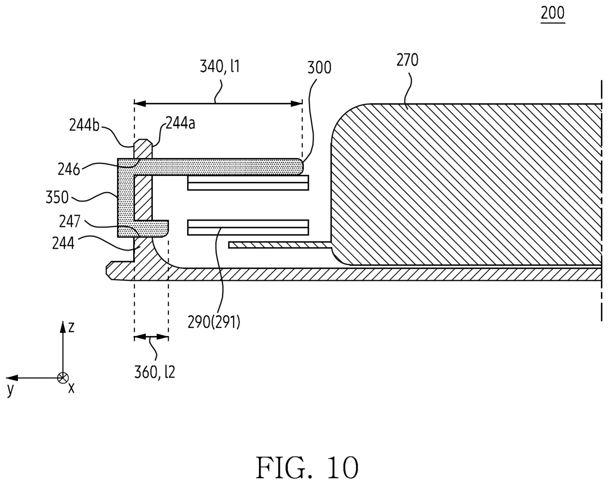

According to an embodiment, the first portion 340 may be contacted on the flexible printed circuit board 290 while being coupled to the at least one partition wall 244. For example, a disposition relationship between the supporting member 300 and the flexible printed circuit board 290 may be described with reference to FIG. 10.

FIG. 10 is a cross-sectional view illustrating an example in which an exemplary electronic device is cut along line F-F' of FIG. 9B according to an embodiment.

Referring to FIG. 10, according to an embodiment, a first portion 340 may be contacted on a bending portion 291 of a flexible printed circuit board 290. The first portion 340 may apply a force in a third direction (e.g., a -z direction) to the bending portion 291 of the flexible printed circuit board 290. The first portion 340 may protrude from an inner surface 244a of a partition wall 244 by being inserted into a first through-hole 246. For example, the first portion 340 may have a shape extending from the inner surface 244a of the partition wall 244 along a direction (e.g., a -y direction) opposite to a first direction (e.g., a +y direction). The first portion 340 may be brought into contact with the bending portion 291 by protruding from the inner surface 244a of the partition wall 244. As the first portion 340 applies the force in the third direction (e.g., the -z direction) to the bending portion 291, a reaction force of the flexible printed circuit board 290 may not be transmitted to another component of the electronic device 200.

According to an embodiment, a third portion 360 may protrude from the inner surface 244a of the partition wall 244 by being inserted into a second through-hole 247. For example, the first portion 340 may have a first length l1. For example, the third portion 360 may have a second length l2 shorter than the first length l1. Since the second length l2 of the third portion 360 is shorter than the first length 11 of the first portion 340, the third portion 360 may be spaced apart from the bending portion 291 while protruding from the inner surface 244a of the partition wall 244. However, it is not limited thereto. For example, the third portion 360 may not protrude from the inner surface 244a of the partition wall 244. For example, an entire region of the third portion 360 may be received only in the second through-hole 247.

According to an embodiment, a second portion 350 may be disposed outside the partition wall 244. The second portion 350 may be positioned (or disposed) on an outer surface 244b of the partition wall 244. The second portion 350 may be contacted on the outer surface 244b of the partition wall 244. The second portion 350 may support the first portion 340 and the third portion 360 so that a position of the supporting member 300 is maintained by contacting the outer surface 244b of the partition wall 244.

As described above, the electronic device 200 according to an embodiment may provide a structure in which a position of the flexible printed circuit board 290 within the partition wall 244 may be maintained, since the supporting member 300 includes the first portion 340 contacted on the bending portion 291 by penetrating at least one partition wall 244.

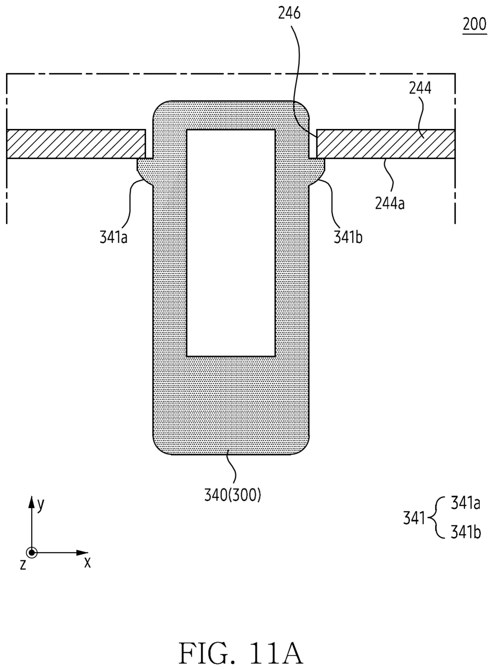

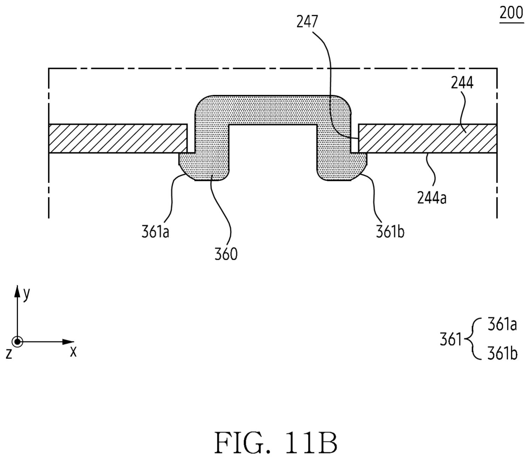

For example, the position of the supporting member 300 may be maintained by one or more first fastening protrusions (e.g., the one or more first fastening protrusions 341 of FIGS. 9A and 9B) and one or more second fastening protrusions (e.g., the one or more second fastening protrusions 361 of FIGS. 9A and 9B). For example, the position of the supporting member 300 being maintained by the one or more first fastening protrusions 341 and the one or more second fastening protrusions 361 may be described with reference to FIGS. 11A and 11B.

FIG. 11A is a cross-sectional view illustrating an example in which an exemplary electronic device is cut along line G-G' of FIG. 9B according to an embodiment, and FIG. 11B is a cross-sectional view illustrating an example in which an exemplary electronic device is cut along line H-H' of FIG. 9B according to an embodiment.

Referring to FIGS. 11A and 11B, According to an embodiment, one or more first fastening protrusions 341 may be disposed on an inner surface 244a of a partition wall 244. The one or more first fastening protrusions 341 may be contacted on the inner surface 244a of the partition wall 244. For example, in a case that the one or more first fastening protrusions 341 include a plurality of first fastening protrusions 341a and 341b, a distance between the plurality of first fastening protrusions 341a and 341b may be greater than a width of a first through-hole 246. As the one or more first fastening protrusions 341 are disposed on the inner surface 244a of the partition wall 244, movement of a supporting member 300 in a first direction (e.g., a +y direction) may be restricted.

According to an embodiment, one or more second fastening protrusions 361 may be disposed on the inner surface 244a of the partition wall 244. The one or more second fastening protrusions 361 may be contacted on the inner surface 244a of the partition wall 244. For example, in a case that the one or more second fastening protrusions 361 include a plurality of second fastening protrusions 361a and 361b, a distance between the plurality of second fastening protrusions 361a and 361b may be greater than a width of a second through-hole 247. As the one or more second fastening protrusions 361 are disposed on the inner surface 244a of the partition wall 244, the movement of the supporting member 300 in the first direction (e.g., the +y direction) may be restricted.

As described above, an electronic device 200 according to an embodiment may provide a structure in which a position of the supporting member 300 may be maintained by the one or more first fastening protrusions 341 and the one or more second fastening protrusions 361.

A flexible printed circuit board disposed in an electronic device may be disposed in the electronic device in a state in which at least a portion of the flexible printed circuit board is bent. As the at least a portion of the flexible printed circuit board is bent, a reaction force may be generated in the flexible printed circuit board. In a case that the reaction force of the flexible printed circuit board is transmitted to other components in the electronic device, damage to the other components in the electronic device may occur. The electronic device may need a structure capable of reducing the reaction force of the flexible printed circuit board.

An electronic device (e.g., the electronic device 200 of FIGS. 4A and 4B) is provided. The electronic device according to an embodiment may comprise a frame (e.g., the frame 240 of FIGS. 4A and 4B) including a first surface (e.g., the first surface 240a of FIG. 4B) and a partition wall (e.g., the partition wall 244 of FIGS. 4A and 4B) protruded from the first surface. According to an embodiment, the electronic device may comprise a battery (e.g., the battery 270 of FIG. 4A) disposed on the first surface to be surrounded by the partition wall. According to an embodiment, the electronic device may comprise a flexible printed circuit board (e.g., the flexible printed circuit board 290 of FIG. 4A), including a bending portion (e.g., the bending portion 291 of FIG. 4A) which is bent within the partition wall, connected to the battery. According to an embodiment, the electronic device may comprise a supporting member (e.g., the supporting member 300 of FIGS. 4A and 4B) movably coupled to the partition wall. According to an embodiment, a position of the supporting member may include a first position contacted on the bending portion to apply a force in a direction toward the first surface to the bending portion, and a second position spaced apart from the bending portion.

The electronic device according to an embodiment may provide a structure capable of maintaining the position in the partition wall of the flexible printed circuit board by the supporting member pressing the flexible printed circuit board.

According to an embodiment, the supporting member may move from the second position to the first position by rotating in a first rotational direction or be movable from the first position to the second position by rotating in a second rotational direction opposite to the first rotational direction.

The electronic device according to an embodiment may provide a structure in which the battery and the frame are easily separated or assembled by the supporting member movable with respect to the frame.

According to an embodiment, the partition wall may include a first coupling portion (e.g., the first coupling portion 245 of FIG. 4B) surrounded by the supporting member. According to an embodiment, the supporting member may include a second coupling portion (e.g., the second coupling portion 310 of FIG. 4B), having a shape corresponding to the first coupling portion, configured to maintain a position of the supporting member by engaging with the first coupling portion.

The electronic device according to an embodiment may provide a structure in which the position of the supporting member on the flexible printed circuit board may be maintained by the first coupling portion and the second coupling portion engaging with each other.

According to an embodiment, a cross section of the first coupling portion has a shape extending in a first direction toward the first surface. According to an embodiment, the second coupling portion may include a first opening (e.g., the first opening 311 of FIG. 5) and a second opening (e.g., the second opening 312 of FIG. 5) intersecting the first opening. According to an embodiment, the first coupling portion may be received within the second opening when the position of the supporting member is the first position and may be received within the first opening when the position of the supporting member is the second position.

The electronic device according to an embodiment may provide a structure in which the position of the supporting member on the flexible printed circuit board may be maintained by the second coupling portion including the first opening corresponding to the shape of the first coupling portion and the second opening.

According to an embodiment, the second coupling portion may include one or more coupling protrusions (e.g., the one or more coupling protrusions 313 of FIGS. 7A, 7B, and 7C). According to an embodiment, the one or more coupling protrusions are, when the position of the supporting member is the first position, contacted on an inner surface (e.g., the inner surface 244a of FIGS. 7A, 7B, and 7C) of the partition wall facing the battery, when the position of the supporting member is the second position, contacted on an outer surface (e.g., the outer surface 244b of FIGS. 7A, 7B, and 7C) of the partition wall opposite to the inner surface of the partition wall.

The electronic device according to an embodiment may provide a structure in which the position of the supporting member on the flexible printed circuit board may be maintained by the second coupling portion including one or more fastening protrusions contacted on the inner surface or the outer surface of the partition wall.

According to an embodiment, the partition wall may include one or more coupling grooves (e.g., the one or more coupling grooves 244c of FIG. 7C) formed by the inner surface of the partition wall being depressed. According to an embodiment, the one or more coupling protrusions may be received within the one or more coupling grooves when the position of the supporting member is the first position.

The electronic device according to an embodiment may provide a structure in which the position of the supporting member on the flexible printed circuit board may be maintained by the one or more coupling grooves receiving the one or more fastening protrusions.

According to an embodiment, a portion of the supporting member may be bent with respect to another portion of the supporting member, and may be contacted on the flexible printed circuit board when the position of the supporting member is the first position.

The electronic device according to an embodiment may provide a structure capable of pressing the flexible printed circuit board by a pressing portion bent with respect to an extending portion of the supporting member.

According to an embodiment, the electronic device may comprise a printed circuit board (e.g., the first printed circuit board 250 of FIG. 4A), including a first connector (e.g., the first connector 250a of FIG. 4A), disposed in the frame. According to an embodiment, the flexible printed circuit board may further include a connector portion (e.g., the connector portion 292 of FIG. 4A), connected to the bending portion, including a second connector (e.g., the second connector 290a of FIG. 4A) coupled to the first connector.

The electronic device according to an embodiment may provide a structure capable of forming an electrical connection in the electronic device through the flexible printed circuit board.

According to an embodiment, the bending portion may be positioned between a lateral side (e.g., the lateral side 270a of FIG. 4A) of the battery facing the printed circuit board and the partition wall when the position of the supporting member is the first position.

According to an embodiment, an end (e.g., the end 300a of FIG. 4B) of the supporting member may be opened toward an outside of the supporting member.

The electronic device according to an embodiment may provide a structure in which the supporting member and the frame are easily coupled, since the supporting member is opened.

According to an embodiment, a portion of the supporting member may be parallel to the first surface when the position of the supporting member is the first position, and may be perpendicular to the first surface when the position of the supporting member is the second position.

The electronic device according to an embodiment may provide a structure in which the battery and the frame are easily separated or assembled by the supporting member movable with respect to the frame.

According to an embodiment, the battery may include a protection circuit module (e.g., the protection circuit module 271 of FIG. 4A) disposed between a portion of a lateral side of the battery and the partition wall. According to an embodiment, the supporting member may be, within the first position, spaced apart from the protection circuit module and positioned between another portion of the lateral side of the battery and the partition wall.

The electronic device according to an embodiment may provide a structure capable of reducing a waste of space inside the frame, since the supporting member is disposed between the battery and at least one partition wall formed as the protection circuit module is disposed.

According to an embodiment, the electronic device may comprise a plate (e.g., the plate 211 of FIG. 5), spaced apart from the partition wall along a direction in which the first surface faces, coupled to the frame. According to an embodiment, the flexible printed circuit board may be spaced apart from the plate by the supporting member.

The electronic device according to an embodiment may provide a structure capable of suppressing the plate from being separated from the frame by a reaction force of the bending portion by the flexible printed circuit board pressing the bending portion.

An electronic device (e.g., the electronic device 200 of FIGS. 4A and 4B) is provided. According to an embodiment, the electronic device may comprise a frame (e.g., the frame 240 of FIGS. 4A and 4B) including a first surface (e.g., the first surface 240a of FIG. 4B), a partition wall (e.g., the partition wall 244 of FIGS. 4A and 4B) protruded from the first surface, and a first through-hole (e.g., the first through-hole 246 of FIG. 9A) formed in the partition wall. According to an embodiment, the electronic device may comprise a battery (e.g., the battery 270 of FIG. 4A) disposed on the first surface to be surrounded by the partition wall. According to an embodiment, the electronic device may comprise a flexible printed circuit board (e.g., the flexible printed circuit board 290 of FIG. 4A), including a bending portion (e.g., the bending portion 291 of FIG. 4A) which is bent within the partition wall, connected to the battery. According to an embodiment, the electronic device may comprise a supporting member (e.g., the supporting member 300 of FIG. 9A), including a first portion (e.g., the first portion 340 of FIG. 9A) passing through the first through-hole and a second portion (e.g., the second portion 350 of FIG. 9A) connected to the first portion, separable from the partition wall. According to an embodiment, the first portion may be contacted on the bending portion to apply a force in a direction toward the first surface to the bending portion. According to an embodiment, the second portion may be positioned on an outer surface (e.g., the outer surface 244b of FIG. 9A) of the partition wall opposite to an inner surface (e.g., the inner surface 244a of FIG. 9A) of the partition wall facing the battery.

The electronic device according to an embodiment may provide a structure capable of maintaining a position in the partition wall of the flexible printed circuit board by the supporting member pressing the flexible printed circuit board.

According to an embodiment, the frame may include a second through-hole (e.g., the second through-hole 247 of FIG. 9A). According to an embodiment, the supporting member may include a third portion (e.g., the third portion 360 of FIG. 9A), spaced apart from the first portion, connected to the second portion, and passing through the second through-hole. According to an embodiment, the first portion may be contacted on the bending portion by protruding from the inner surface of the partition wall. According to an embodiment, the third portion may be spaced apart from the bending portion while protruding from the inner surface of the partition wall.

The electronic device according to an embodiment may provide a structure capable of maintaining the position in the partition wall of the flexible printed circuit board by the supporting member pressing the flexible printed circuit board.

According to an embodiment, the frame may include a second through-hole (e.g., the second through-hole 247 of FIG. 9A). According to an embodiment, the supporting member may include a third portion (e.g., the third portion 360 of FIG. 9A), spaced apart from the first portion, connected to the second portion, and passing through the second through-hole. According to an embodiment, the first portion may include one or more first fastening protrusions (e.g., the one or more first fastening protrusions 341 of FIG. 9A) contacted on the inner surface of the partition wall to maintain a position of the supporting member. According to an embodiment, the third portion may include one or more second fastening protrusions (e.g., the one or more second fastening protrusions 361 of FIG. 9A) contacted on the inner surface of the partition wall to maintain the position of the supporting member.

The electronic device according to an embodiment may provide a structure in which the position of the supporting member may be maintained by the one or more first fastening protrusions and the one or more second fastening protrusions.

According to an embodiment, the one or more first fastening protrusions and the one or more second fastening protrusions may have a shape inclined with respect to a direction in which the inner surface of the partition wall faces.

The electronic device according to an embodiment may provide a structure in which the supporting member and at least one partition wall are easily assembled, since the one or more first fastening protrusions and the one or more second fastening protrusions have the inclined shape.

According to an embodiment, the first portion may include an opening (e.g., the opening 342 in FIG. 9A) penetrating the first portion so that the first portion may be deformed.

The electronic device according to an embodiment may provide a structure in which the supporting member and the at least one partition wall are easily assembled, since the first portion may be deformed by the opening formed in the first portion.

According to an embodiment, the frame may include a second through-hole (e.g., the second through-hole 247 of FIG. 9A). According to an embodiment, the supporting member may include a third portion (e.g., the third portion 360 of FIG. 9A), spaced apart from the first portion, connected to the second portion, and passing through the second through-hole. According to an embodiment, the third portion may have a shape opened toward the battery to allow the third portion to be deformed.

The electronic device according to an embodiment may provide a structure in which the supporting member and the at least one partition wall are easily assembled, since the third portion may be deformed by having an opened shape.

An electronic device (e.g., the electronic device 200 of FIGS. 4A and 4B) is provided. According to an embodiment, the electronic device may comprise a frame (e.g., the frame 240 of FIGS. 4A and 4B). According to an embodiment, the electronic device may comprise an electronic component (e.g., the battery 270 of FIG. 4A) disposed on a first surface (e.g., the first surface 240a of FIG. 4B) of the frame. According to an embodiment, the electronic device may comprise a bending portion (e.g., the bending portion 291 of FIG. 4A) having a shape which is bent, and a flexible printed circuit board (e.g., the flexible printed circuit board 290 of FIG. 4A) connected to the electronic component. According to an embodiment, the electronic device may comprise a supporting member (e.g., the supporting member 300 of FIGS. 4A and 4B) that is movably coupled to the frame. According to an embodiment, the supporting member may be contacted on the bending portion to apply force to the flexible printed circuit board in a direction facing the first surface by being moved with respect to the frame, or may be spaced apart from the bending portion.

The electronic device according to an embodiment may provide a structure capable of maintaining a position in a partition wall of the flexible printed circuit board by the supporting member pressing the flexible printed circuit board.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101; 200) comprising:
a frame (240) including a first surface (240a) and a partition wall (244) protruded from the first surface (240a);
a battery (270) disposed on the first surface (240a) to be surrounded by the partition wall (244);
a flexible printed circuit board (290), including a bending portion (291) which is bent within the partition wall (244), connected to the battery (270); and
a supporting member (300) movably coupled to the partition wall (244),
wherein a position of the supporting member (300) includes:
a first position contacted on the bending portion (291) to apply force in a direction toward the first surface (240a) to the bending portion (291), and
a second position spaced apart from the bending portion (291).

2. The electronic device (101; 200) of claim 1,
wherein the supporting member (300) moves from the second position to the first position by rotating in a first rotational direction or movable from the first position to the second position by rotating in a second rotational direction opposite to the first rotational direction.

3. The electronic device (101; 200) of any one of claims 1 and 2,
wherein the partition wall (244) includes a first coupling portion (245) surrounded by the supporting member (300), and
wherein the supporting member (300) includes a second coupling portion (310), having a shape corresponding to the first coupling portion (245), configured to maintain a position of the supporting member (300) by engaging with the first coupling portion (245).

4. The electronic device (101; 200) of claim 3,
wherein a cross section of the first coupling portion (245) has a shape extending in a first direction toward the first surface (240a),
wherein the second coupling portion (310) includes:
a first opening (311); and
a second opening (312) intersecting the first opening (311), and
wherein the first coupling portion (245) is received within the second opening (312) when the position of the supporting member (300) is the first position and is received within the first opening (311) when the position of the supporting member (300) is the second position.

5. The electronic device (101; 200) of claim 3,
wherein the second coupling portion (310) includes one or more coupling protrusions (313),
wherein the one or more coupling protrusions (313) are:
when the position of the supporting member (300) is the first position, contacted on an inner surface (244a) of the partition wall (244) facing the battery (270), and
when the position of the supporting member (300) is the second position, contacted on an outer surface (244b) of the partition wall (244) opposite to the inner surface (244a) of the partition wall (244).

6. The electronic device (101; 200) of claim 5,
wherein the partition wall (244) includes one or more coupling grooves (244c) formed by the inner surface (244a) of the partition wall (244) being depressed, and
wherein the one or more coupling protrusions (313) are received within the one or more coupling grooves (244c) when the position of the supporting member (300) is the first position.

7. The electronic device (101; 200) of any one of claims 1 to 6,
wherein a portion of the supporting member (300) is bent with respect to another portion of the supporting member (300), and is contacted on the flexible printed circuit board (290) when the position of the supporting member (300) is the first position.

8. The electronic device (101; 200) of any one of claims 1 to 7, further comprising:
a printed circuit board (250), including a first connector (250a), disposed in the frame (240), and
wherein the flexible printed circuit board (290) further includes:
a connector portion (292), connected to the bending portion (291), including a second connector (290a) coupled to the first connector (250a).

9. The electronic device (101; 200) of claim 8,
wherein the bending portion (291) is positioned between a lateral side (270a) of the battery (270) facing the printed circuit board (250) and the partition wall (244) when the position of the supporting member (300) is the first position.

10. The electronic device (101; 200) of any one of claims 1 to 9,
wherein an end (300a) of the supporting member (300) is opened toward an outside of the supporting member (300).

11. The electronic device (101; 200) of any one of claims 1 to 10,
wherein a portion of the supporting member (300) is:
parallel to the first surface (240a) when the position of the supporting member (300) is the first position, and
perpendicular to the first surface (240a) when the position of the supporting member (300) is the second position.

12. The electronic device (101; 200) of any one of claims 1 to 11,
wherein the battery (270) includes a protection circuit module disposed between a portion of a lateral side (270a) of the battery (270) and the partition wall (244), and
wherein the supporting member (300) is, within the first position, spaced apart from the protection circuit module and is positioned between another portion of the lateral side (270a) of the battery (270) and the partition wall (244).

13. The electronic device (101; 200) of any one of claims 1 to 12, further comprising:
a plate (211), spaced apart from the partition wall (244) along a direction in which the first surface (240a) faces, coupled to the frame (240), and
wherein the flexible printed circuit board (290) is spaced apart from the plate (211) by the supporting member (300).

14. An electronic device (101; 200) comprising:
a frame (240) including a first surface (240a), a partition wall (244) protruded from the first surface (240a), and a first through-hole (246) formed in the partition wall (244);
a battery (270) disposed on the first surface (240a) to be surrounded by the partition wall (244);
a flexible printed circuit board (290), including a bending portion (291) which is bent within the partition wall (244), connected to the battery (270); and
a supporting member (300), including a first portion (340) passing through the first through-hole (246) and a second portion (350) connected to the first portion (340), separable from the partition wall (244),
wherein the first portion (340) is contacted on the bending portion (291) to apply a force in a direction toward the first surface (240a) to the bending portion (291), and
wherein the second portion (350) is positioned on an outer surface (244b) of the partition wall (244) opposite to an inner surface (244a) of the partition wall (244) facing the battery (270).

15. The electronic device (101; 200) of claim 14,
wherein the frame further includes:
a second through-hole (247), spaced apart from the first through-hole (246), formed in the partition wall (244),
wherein the supporting member further includes:
a third portion (360), spaced apart from the first portion (340), connected to the second portion (350), and passing through the second through-hole (247),
wherein the first portion (340) is contacted on the bending portion (291) by protruding from the inner surface (244a) of the partition wall (244), and
wherein the third portion (360) is spaced apart from the bending portion (291) while protruding from the inner surface (244a) of the partition wall (244).
